# EUROPEAN PATENT APPLICATION

(11) **EP 1 732 279 A2**
(43) Date of publication of application: **13.12.2006**
(21) Application number: 06100624.3
(22) Date of filing: 19.01.2006
(51) Int. Cl.: H04L 25/02, H03K 5/01

(54) **A signal shaping circuit**

(30) Priority: 09.06.2005 EP 05105075
(71) Applicant: Agilent Technologies Inc, Palo Alto, CA 94303-0870 (US)
(72) Inventor: MOLL, Joachim, 71083, Herrenberg (DE); LAZAR, Alexander, 70174, Stuttgart (DE); KALKUHL, Christoph, 72070, Tübingen (DE); ROTH, Bernhard, 71034, Böblingen (DE); LUJAN, Michael, 80907-3417, Colorado Springs (US)
(74) Representative: Neuerburg, Gerhard

(57) **Abstract**

The invention relates to a signal shaping circuit (10) for shaping an input signal (18) comprising a first signal path (SP1) with a first transmission behavior and adapted to receive an input signal, and at least one second signal path (SP2-SPn) with a second transmission behavior and adapted to receive an input signal, wherein the outputs of the signal paths (SP1-SPn) are connected to a signal combiner (23) adapted to combine the output signals of the signal paths to an output signal (30) of the signal shaping circuit (10).

## Description

### BACKGROUND ART

The present invention relates to signal shaping.

In digital communication systems, digital data is sent from a transmitter to a receiver in the form of a bit stream over a transmission media such as a copper or fiber line. Typically, these systems are maximized for bandwidth and minimized for errors. A bit error is caused if a receiver of a digital communication system detects a logical zero in a received bit stream instead of a logical one and vice versa. A measure for bit errors in digital communication systems is the bit error ratio - BER.

Particularly, the BER depends on the quality of the received signal containing the digital data. Most receivers of digital communication systems are adapted to regenerate a bit clock from the received signal with a clock and data recovery - CDR - circuit. However, timing aberrations or jitter, respectively, of the received signal usually cause malfunctions of the CDR circuit which result in bad sampling of the digital data transmitted with the received signal causing bit errors.

Jitter is an important issue in high-speed digital communication systems since influences of a transmission channel on the transmitted signal are increasingly important with respect to the BER. Jitter may be distinguished in random jitter - RJ - and deterministic jitter - DJ. One sub-component of DJ is the data dependent jitter - DDJ - which is a function of bit patterns. DDJ is distinguished in Duty Cycle Distortion - DCD- and Inter-Symbol Interference - ISI. ISI is usually caused by long and short bit cycles and results from bandwidth limitations or from loss within transmission channels.

In order to test for jitter, testing signals may be shaped in order to simulate the transmission behavior of a channel.

### DISCLOSURE OF THE INVENTION

It is an object of the present invention to provide an improved signal shaping. The object is solved by the independent claims. Further embodiments are shown by the dependent claims.

According to embodiments of the invention, a signal shaping circuit for shaping an input signal is provided which allows to generate an output signal with a predefined shape. For example, the generated output signal may have a shape like a signal with droop as it is generated by a typical transmission channel. Alternatively, the generated output signal may have a shape like a signal with a peak and a droop such that droop of a transmission channel may be compensated.

According to an embodiment of the invention, a signal shaping circuit for shaping an input signal comprises a first signal path with a first transmission behavior and adapted to receive an input signal, and at least one further signal path with a second transmission behavior and adapted to receive an input signal. The outputs of the signal paths are connected to a signal combiner adapted to combine the output signals of the signal paths to an output signal of the signal shaping circuit.

The transmission behavior of at least one signal path may be adjustable. Thus, it is possible to vary the shaping of the input signal and to simulate different lossy transmission lines or channels.

In a further embodiment, the first signal path comprises a first amplifier, and the at least one second signal path comprises a second amplifier and a low pass filter with an adjustable time constant for adjusting the transmission behavior of the at least one second signal path. The low pass filter implements a transmission behavior comparable to a typical transmission channel or line. This embodiment may be implemented at low cost and allows replacing special filters or boards required for the generation of an output signal of a particularly lossy transmission line or channel.

Furthermore, the amplification of at least one amplifier may be adjustable for adjusting the transmission behavior of a signal path. Thus, the range of adjustment of the shaping of the output signal is increased and the input signal may be shaped in order to generate a wider range of output signals of different particularly lossy transmission lines. Particularly, the amplifier allows amplifying an input signal such that it comprises peaks. Thus, losses of a transmission channel may be compensated.

In a further embodiment, the at least one amplifier is a differential amplifier. The differential amplifier may be implemented with bipolar transistors or field effect transistors (FET). It may comprise an adjustable current source for adjusting the output signal amplitude.

In a further embodiment, the low pass filter of a signal path may comprise a variable capacitor for adjusting the time constant. The variable capacitor may be connected between the output lines of the differential amplifier. This implementation is more symmetrical than an implementation of the low pass filter with two separate and variable capacitors.

In a further embodiment, a decoupling stage is connected between the low pass filter and the signal combiner. The decoupling stage decouples the low pass filter of a signal path from the other signal paths, which enables a more precise signal shaping.

In a further embodiment, the at least one second signal path comprises an input amplifier connected on its input to the input of the signal shaping circuit and on its output to a low pass filter with an adjustable time constant; the output of the low pass filter is connected to the input of a differential amplifier with adjustable amplification.

In a further embodiment, the signal combiner comprises two resistors both connected with one end to a variable voltage source and with the other end to the output lines of the signal paths. The variable voltage source serves to adjust the high level of the output signal.

Furthermore, at least one of the signal paths may comprise an attenuation circuit. The attenuation circuit allows to attenuate the signal amplitude, and thus to further influence the signal shaping.

The signal shaping circuit comprises according to a further embodiment two further signal paths with an adjustable transmission behavior.

A variable capacitor of the signal shaping circuit may be implemented by a circuit comprising two capacitance diodes, a resistor, and a variable voltage source, wherein the cathodes of the two capacitance diodes are connected to the variable voltage source over the resistor.

A variable capacitor of the signal shaping circuit may also be implemented by a circuit comprising several series connections of a switch and a capacitor, wherein the series connections are connected in parallel.

In a further embodiment, the signal shaping circuit is adapted to receive adjusting signals generated by a computer program for automatically adjusting the transmission behavior in accordance with predefined parameters. For example, the predefined parameters may be s parameters of a typical transmission channel, which are input to the computer program. The computer program processes the input parameters and generates adjusting signals for adjusting the transmission behavior in correspondence with the predefined parameters. Thus, a signal shaping circuit is provided which is flexible and may be used for different test applications.

According to a further embodiment of the invention, one second signal path of the signal shaping circuit may comprise a filter and the signal combiner is adapted to combine the inverted output signal of the one second signal path with the filter with the output signals of the other signal paths. For example, this embodiment may be applied in an automatic test equipment-ATE-system for shaping an output signal of a pin electronic of the ATE system in order to stimulate a device under test - DUT - with a signal similar to the output signal of a typical "real world" transmission channel.

According to a further embodiment, at least one signal path may comprise a series connection of a filter and a multiplier, wherein the multiplier is provided for multiplying an output signal of the filter with a control signal in order to adjust the transmission behavior of the signal path. This embodiment has the advantage that is may also be applied in an ATE system and allows to adjust the shaping of an output signal of a pin electronic of the ATE system in order to simulate different transmission channels.

According to a further embodiment of the invention, the control signal may be a digital signal with several predefined states. Thus, the signal shaping may be adjusted to certain predefined states as predetermined by the states of the digital control signal.

According to a further embodiment of the invention, the control signal may be an analog signal adjustable within a predefined amplitude and frequency range. This allows a very flexible adjusting of the signal shaping within the predefined amplitude and frequency range.

According to a further embodiment of the invention, the control signal may be provided by a programmable controller. For example, the controller may be part of an ATE system and provided for controlling the operation of the ATE system. The controller may be programmed by a test program which may comprise instructions for adjusting the control signal within the test program.

Furthermore, an embodiment of the invention relates to a test instrument comprising an signal shaping circuit according to an embodiment of the invention.

According to a further embodiment of the invention, the test instrument may be an automatic test equipment - ATE - system adapted for testing high speed serial data receivers.

According to a further embodiment of the invention, the test instrument may be a pulse data generator adapted for generating a high speed serial data test signal.

According to a further embodiment of the invention, the test instrument may be a bit error ratio - BERT - tester comprising a pulse data generation module which is adapted for generating a high speed serial data signal.

According to a further embodiment of the invention, a signal shaping method for shaping an input signal is provided wherein a first signal path with a first transmission behavior receives an input signal, and at least one second signal path with a second transmission behavior receives an input signal, wherein the outputs of the signal paths are connected to a signal combiner which combines the output signals of the signal paths to an output signal of the signal shaping circuit.

Embodiments of the invention can be partly or entirely embodied or supported by one or more suitable software programs, which can be stored on or otherwise provided by any kind of data carrier, and which might be executed in or by any suitable data processing unit. Software programs or routines are preferably applied to a computer implementing a signal shaping circuit according to embodiments of the invention.

### BRIEF DESCRIPTION OF DRAWINGS

Other objects and many of the attendant advantages of embodiments of the present invention will be readily appreciated and become better understood by reference to the following more detailed description of embodiments in connection with the accompanied drawing(s). Features that are substantially or functionally equal or similar will be referred to by the same reference signs.

Fig. 1 shows a first embodiment of an signal shaping circuit with n signal paths according to the invention;

Fig. 2 shows a second embodiment of an signal shaping circuit with two signal paths according to the invention;

Fig. 3 shows a first embodiment of a signal path unit according to the invention;

Fig. 4 shows a second embodiment of a signal path unit according to the invention;

Fig. 5 shows a third embodiment of a signal path unit according to the invention;

Fig. 6 shows a first embodiment of a variable capacitor for usage with the signal shaping circuit according to the invention;

Fig. 7 shows a second embodiment of a variable capacitor for usage with the signal shaping circuit according to the invention;

Fig. 8 shows a test instrument containing an amplifier with a signal shaping circuit according to an embodiment of the invention;

Fig. 9 shows the shaping of an input signal according to an embodiment of the invention, wherein the shaped signal is similar to an output signal of a typical transmission channel;

Fig. 10 shows the shaping of an input signal according to an embodiment of the invention, wherein the shaped signal comprises a peak in order to compensate loss of a typical transmission channel;

Fig. 11 shows a first embodiment of a signal shaping circuit according to the invention for the application in an ATE system in order to simulate a transmission channel;

Fig. 12 shows a second embodiment of a signal shaping circuit according to the invention for the application in an ATE system in order to simulate a transmission channel; and

Fig. 13 shows a third embodiment of a signal shaping circuit according to the invention for the application in an ATE system in order to simulate a transmission channel.

Real transmission channels, particularly transmission lines such as copper or optical lines behave like a low or high pass filter with a non-linear phase characteristic. The filter effect of a real transmission channel causes a bandwidth limitation. Furthermore, loss in a transmission channel causes droop, which limits signal settling before the next signal transition occurs. Both the bandwidth limitations and the droop lead to a shortening of bits in a bit stream since usually a bit has not yet settled, i.e., reached about 100% of its amplitude before the next signal transition occur. Especially in high-speed digital communication systems with data rates in the range of 1 gigabit per second (GB/s) and short times of some picoseconds (ps) between two signal transitions, jitter such as DCD and ISI may essentially influence the opening of the eye in an eye diagram of a received signal containing digital data, or in other words may lead to a closing of the eye. Especially at high frequencies, the physical behavior of the material of a transmission channel limits the bandwidth, particularly if the channel is a long fiber line or a cheap PCB material. Thus, a test of components of high-speed digital communication system with signals containing jitter caused by a transmission channel is important with regard to the BER. In order to simulate an output signal of a typical transmission channel, a signal shaping circuit may be used.

In the following, several embodiments of signal shaping circuits according to the invention and of its components are described in detail. The embodiments of the signal shaping circuit may be part of a particularly integrated amplifier which is applied in a test instrument such as a bit error ratio tester - BERT - or a pulse data generator.

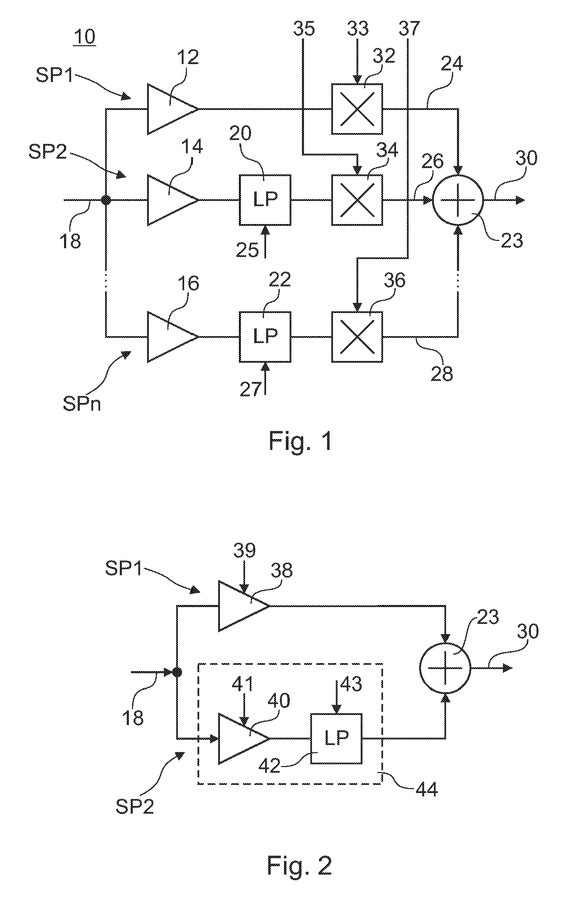

Fig. 1 shows a block diagram of an signal shaping circuit 10 according to the invention with which time constants and gain in the signal paths SP1, SP2 to SPn of the circuit 10 may be mapped to transition time and droop of an output signal 30 of the circuit 10 in order to reproduce an output signal of a typical transmission channel such as a copper of optical line of a high-speed digital communication system. The circuit 10 comprises a first signal path SP1, and several second signal paths SP2 to SPn with low pass filters 20 and 22 with an adjustable time constant. The low pass filters 20 and 22 may be first-, second- or higher-order filters and implement a transmission behavior, which is comparable to a typical transmission channel such a fiber or copper line.

Each signal path SP1, SP2 to SPn of the circuit 10 contains an amplifier 12, 14, and 16 for amplifying an incoming input signal 18. The input signal 18 may be a typical bit stream of digital data as it is transmitted from a sender to a receiver of a high-speed digital communication system. For example, a bit stream of "1"and "0" may be simulated by a square-wave pulse signal. The input signal 18 is amplified in each of the signal paths SP1, SP2 to SPn by the amplifiers 12, 14, and 16. After amplification, the input signal is supplied to the low pass filters 20 and 22 in the second signal paths SP2 to SPn. The low pass filters 20 and 22 "introduce" a time constant in the input signal for simulating the behavior of a typical transmission line with a capacitance and resistance per unit length. The time constant can be adjusted with time constant adjusting signals 25 to 27.

In the first signal path SP1, the amplified input signal is directly supplied to an attenuator 32 with adjustable attenuation, which adjusts the level of the supplied signal as set by a control signal 33 for adjusting the attenuation. In the second signal paths SP2 to SPn, the amplified input signal 18 is filtered by the low pass filters 20 and 22 and then attenuated by adjustable attenuators 34 and 36 the attenuation of which is adjusted by control signals 35 and 37, respectively. The output signal 24 of the first signal path SP1 and the output signals 26 and 28 of the second signal paths SP2 to SPn are combined by a signal combiner 23, which is an adder circuit, in order to generate an output signal 30 which reproduces an output signal of a real transmission channel. The signal combiner may also be a subtractor for subtracting received signals. It may also be a universal signal combiner, which adds the output signal of some signal paths and subtracts output signals of other signal paths.

The shape of the output signal 30 may be varied by the adjustment of the time constants of the low pass filters 20 and 22 with the time constant adjusting signals 25 and 27 and the attenuation of the attenuators 32, 34, and 36 with the attenuation adjusting signals 33, 35, and 37. Thus, the transition time and droop of different transmission channels may be simulated by setting the time constants of the low pass filters 20 and 22 and the attenuation of the attenuators 32, 34, and 36. Particularly, the adjustment of the time constants and attenuations may be adapted such that the course of the output signal 30 essentially matches real measurements of a transmission channel. It has been shown that two time constants appear to be sufficient to simulate the real behavior of a transmission channel. In order to simulate typical transmission channels for signals with data rates in the range of GB/s, the two time constants should be variable from 20 ps to 250 ps and from 300 ps to 3 ns.

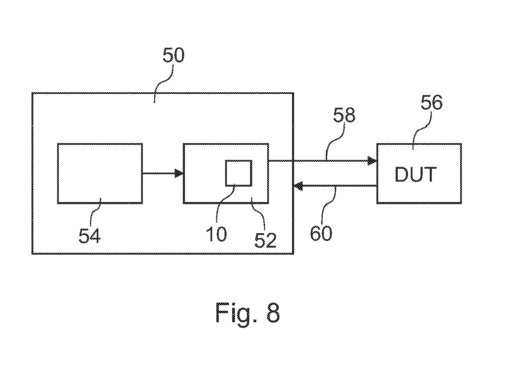

The adjustment of the time constants of the low pass filters 20 and 22 with the time constant adjusting signals 25 and 27 and the attenuation of the attenuators 32, 34, and 36 with the attenuation adjusting signals 33, 35, and 37 may be controlled by a computer program. For example, the signal shaping circuit 10 may be integrated in a test instrument (as it is shown in Fig. 8) comprising a processor executing a test computer program. The test computer program may be programmed to automatically adjust the shaping of the input signal 18 by the signal shaping circuit 10 in that it controls the time constant adjusting signals 25 and 27 and the attenuation adjusting signals 33, 35, and 37. Furthermore, it may be possible to load adjusting data such as s parameters for a typical transmission channel into the test instrument which are processed by the test computers program which adjusts the signal shaping corresponding to the loaded adjusting data. Thus, a test instrument is provided with a highly flexible test signal generation.

Fig. 2 shows a further block diagram of an signal shaping circuit with a first and one second signal path SP1 and SP2, respectively. In contrast to the circuit of Fig. 1, both signal paths SP1 and SP2 comprise amplifiers 38 and 40 with an adjustable gain and attenuation so that the input signal 18 supplied to both signal paths may be amplified or attenuated corresponding to the respective adjustment of the amplifier 38 or 40. This is to illustrate that attenuation may be implemented also directly within the amplifier.

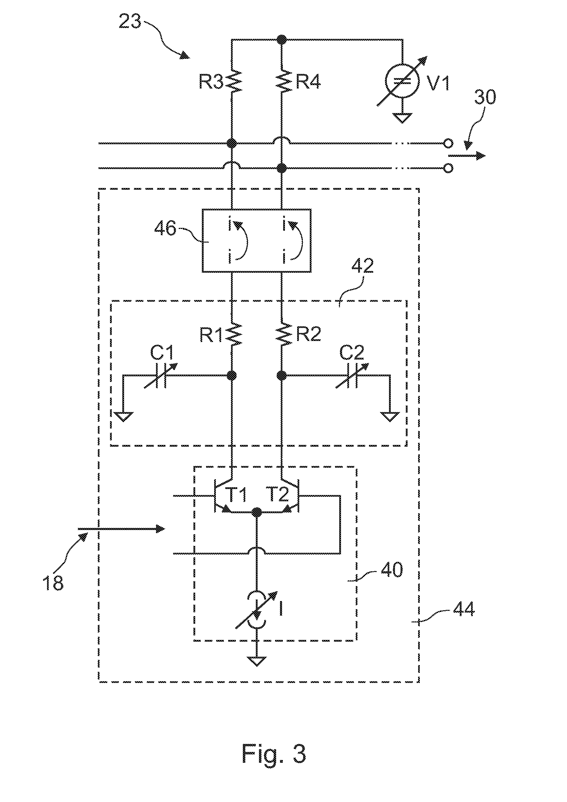

By inverting the slower path, an output signal 30 may be generated which may be input to a real transmission channel such as a copper line and generate an output signal of the transmission channel which reproduces the ideal output signal of a signal generator. Therefore, the influence of a real transmission channel on a signal may be compensated. This may be relevant if a device under test - DUT - is tested with the output signal 30 but connected to the signal shaping circuit by a long transmission line. The second signal path SP2 further comprises a low pass filter 42 with an adjustable time constant. The amplifier 40 and the filter 42 of the second signal path may be integrated as single unit 44, embodiments of which are shown in Figs. 3 to 5. It should be noted that unit 44 may also be applied in the circuit shown in Fig. 1 (instead of the series connection of an amplifier, low pass filter, and attenuator).

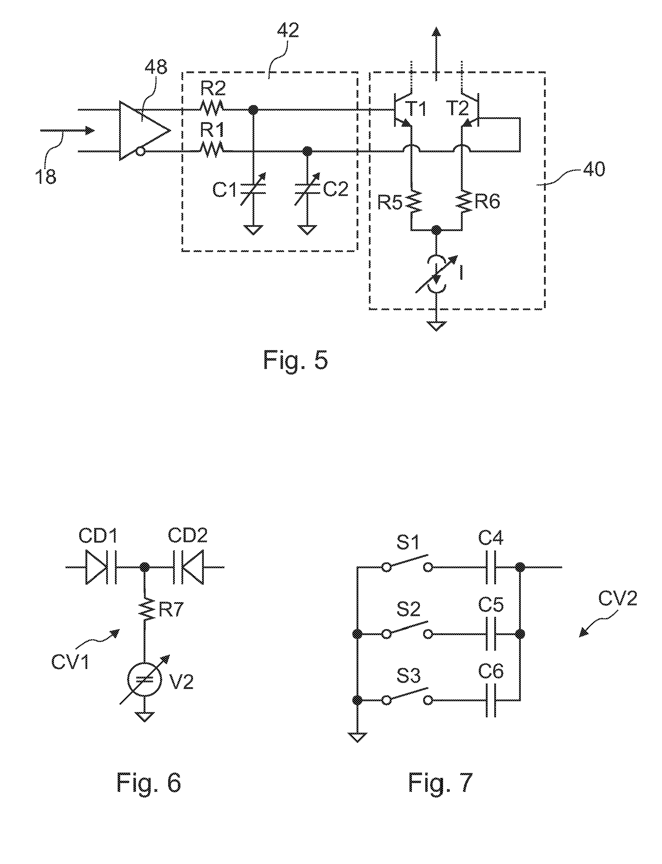

In the following, embodiments of the unit 44 of Fig. 2 will be explained in detail. It should be noted that the npn bipolar transistors of the circuits of Figs. 3 to 5 may be any switching element such as a pnp bipolar or any kind of FET in an equivalent circuit. Thus, the invention is not limited to the application of npn bipolar transistors. Also, the variable capacitors of these circuits may be any kind of variable capacitor. Preferred embodiments of variable capacitors for the circuits of Figs. 3 to 5 are shown in Figs. 6 and 7. Unit 44 comprises a differential amplifier 40 for amplifying the input signal 18. The differential amplifier 40 comprises a differential pair of npn bipolar transistors T1 and T2 and a current source I. The emitters of the transistors T1 and T2 are connected to the current source I. The input signal 18 is supplied to the basis of the transistors T1 and T2, which form the input of the amplifier 40. The collectors of the transistors T1 and T2 are connected to a low pass filter 42 with an adjustable time constant. The low pass filter 42 comprises two resistors R1 and R2 and two variable capacitors C1 and C1. Resistor R1 and capacitor C1 form a first low pass filter component connected to the collector of transistor T1, and resistor R2 and capacitor C2 form a second low pass filter component connected to the collector of transistor T2. By varying the capacity of the capacitors C1 and C2, the time constant of the low pass filter 42 may be varied over a wide range. Unit 44 further comprises a decoupling stage 46 for decoupling the amplifier 40 and low pass filter 42 from the output of the signal shaping circuit. The decoupling stage 46 causes a decoupling of the time constants of all signal paths The signal combiner 23 comprises two resistors R3 and R4 which connect the outputs of the signal paths to an adjustable voltage source V1.

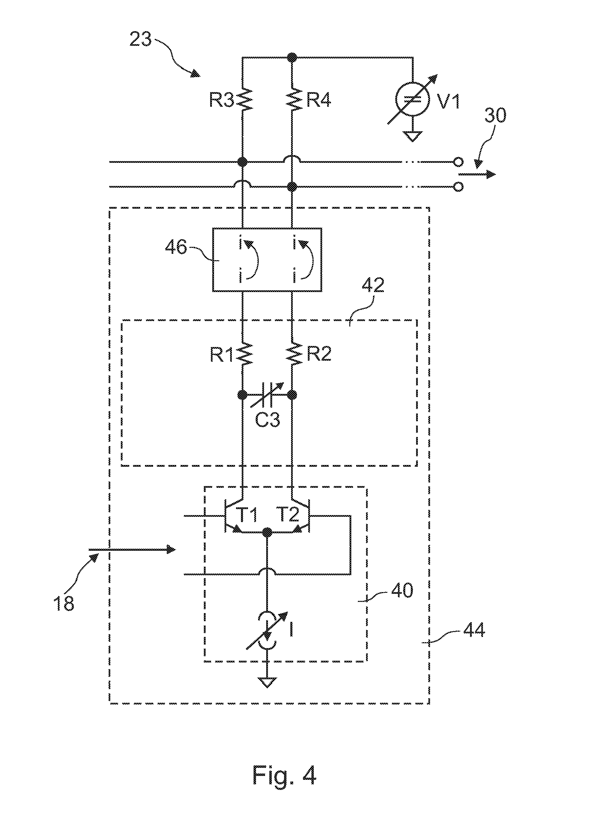

Fig. 4 shows a further embodiment of the unit 44 of Fig. 2 which differs from the embodiment of Fig. 3 in that instead of two variable capacitors C1 and C2 only one variable capacitor C3 is connected between the two output lines of the differential amplifier 40. Particularly, the different implementations take into account which physical implementation is better feasible in a chosen manufacturing process.

A third embodiment of the unit 44 of Fig. 2 is shown in Fig. 5. In this embodiment, input signal 18 is pre-amplified by an input amplifier 48 with a differential output pair. Then the differential input signal is filtered by a low pass filter 42 with variable time constant. The low pass filter 42 comprises two low pass filters R1, C1 and R2, C2 with variable capacitors for each signal line of the differential signal. The output of the low pass filter 42 is connected to the input of a differential amplifier 40, which amplifies the filtered differential input signal.

Fig. 6 shows an implementation of a variable capacitor CV1 as it may be applied with the invention. The variable capacitor C comprises two capacitance diodes CD1 and CD2. The cathodes of both diodes CD1 and CD2 are connected to a resistor R7, which connects the cathodes with a variable voltage source V2. By varying the voltage source V2, the capacity of the shown capacitor C may be adjusted stepless.

Fig. 7 shows a further embodiment of a variable capacitor CV2 consisting of three series connections of a switch and a capacitor, wherein the series connections are switched in parallel. The capacitance of the three capacitors C4, C5, and C5 may differ or be similar. By closing either one or more of the three switches S1, S2, and S3, the entire capacitance of the variable capacitor C may be adjusted. In contrast to the variable capacitor CV1, the capacitance of capacitor CV2 may be varied only in steps. Also, the adjustment range of the variable capacitor CV2 depends on the largest and smallest capacitance used in this circuit. Furthermore, adjustment resolution depends on the number of different capacitors applied for the series connections.

Fig. 8 shows a test instrument 50 such as a BERT, which comprises a signal generation unit 54 for generating a test signal for a DUT 56. The signal generated by unit 54 is amplified by an amplifier 52, which contains a signal shaping circuit 10 according to an embodiment of the invention. If the signal shaping circuit 10 is enabled, i.e., the signal is processed by the unit 10 in the amplifier, the output signal 58 may be a reproduction of an output signal of a real transmission channel. The output signal 58 is then supplied to an input pin of the DUT 56. The response signal 60 of the DUT 56 is fed back to the test instrument 50 for analyzing it e.g. for jitter. Thus, the output signal 58 may be adapted such that it is similar to an output signal of a real transmission channel such as a long copper or fiber line. On the contrary, it may also be possible to adapt the output signal 58 to a real transmission channel such that the output signal of the real transmission channel is like an ideal input signal for the DUT 56. This allows to compensate effects of the transmission channel and to test the DUT 56 as without the real transmission channel.

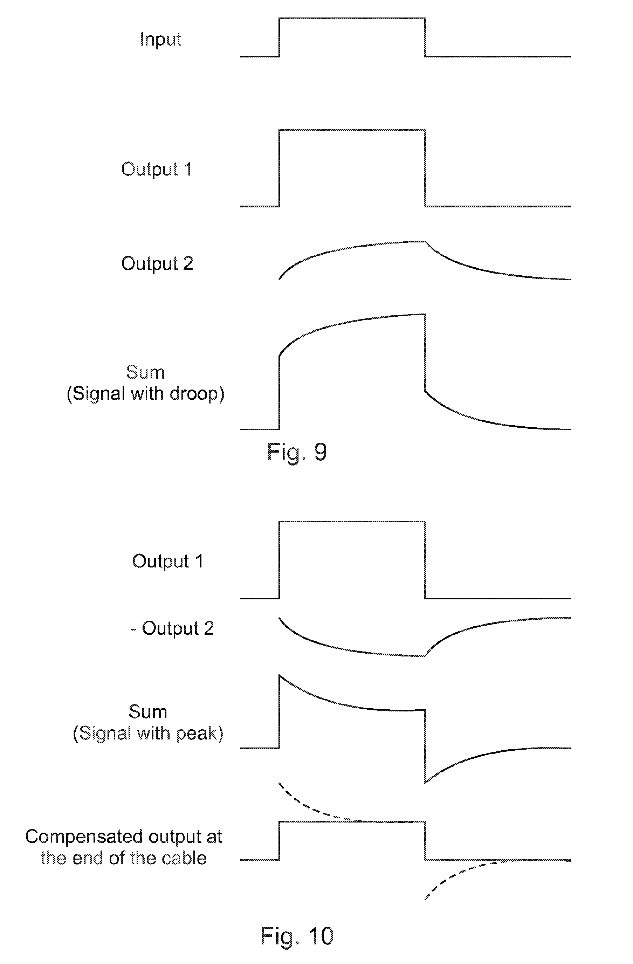

Fig. 9 shows in input signal of a signal shaping circuit according to an embodiment of the invention with two signal paths. The first signal path amplifies the input signal to a signal output 1. The second signal path delays the input signal such that a signal output 2 is generated similar to an output signal of a transmission channel with a time constant and signal droop. The output signal sum of the signal shaping circuit is generated by adding the signals output 1 and output 2. This output signal sum is similar to an output signal of a typical transmission channel introducing droop to an input signal of the transmission channel.

Fig. 10 shows the generation of an output signal of the signal shaping circuit, which is supplied to a transmission channel in order to generate an output signal of the transmission channel which is similar to the input signal of the signal shaping circuit. Thus, effects of the transmission channel on a signal may be compensated. In contrast to Fig. 9, the output signal output 2 of the second signal path is inverted before adding it to the output signal output 1 of the first signal path. Thus, an output signal sum of the signal shaping circuit containing a peak and droop is achieved. The peak serves to compensate any loss in the transmission channel, as the compensated output at the end of the transmission channel (which is a cable) demonstrates.

As mentioned above, the transmission behavior of a transmission channel becomes more and more important with increasing data rates. Particularly, high speed serial data transmissions with data rates of 1 GBit/s or more increasingly face the problem of a frequency-dependent signal attenuation due to the signal path itself. These attenuations may limit the achievable data rate because the timing window for a data bit at a receiver of the transmitted data shrinks much faster than the nominal bit period given by the data rate. This causes a closing of the data eye measured at the receiver side and makes it much more difficult to reconstruct data from a received serial bit stream. In order to alleviate this problem, receivers or transmitters often utilize equalization techniques with which higher frequencies contained in a transmitted or received signal, respectively, are more amplified than lower frequencies in order to compensate a low pass characteristic of a typical transmission channel. It is more popular to implement such equalization techniques in receivers since techniques and algorithms can be applied in such devices which are independent of the length of a transmission channel (path length). Preferably, an equalization is performed in the digital domain with digital signal processing techniques. However, testing of such receiver devices with a commercial ATE (Automatic Test Equipment) system is difficult since most available ATE systems are designed to deliver "clean" signals to a DUT. A "clean" signal means a signal with a nearly ideal signal shape such as the signal "input" or "output 1" shown in Fig. 9, in comparison to a "real world" transmission channel output signal such as the signal "output 2" shown in Fig. 9. In order to achieve such "clean" signals It is known to compensate signal path attenuations in ATE systems which are caused by electrical lines conducting stimuli signals from the pin electronics of the ATE system to the DUT. US6239667 B1, US6360180 B1, and JP7007375A describe compensation techniques. However, for testing receiver devices for data rates in the range of GBit/s, which comprise equalization functionality, an ATE system is required which is able to generate and deliver output signals of typical transmission channels to a DUT.

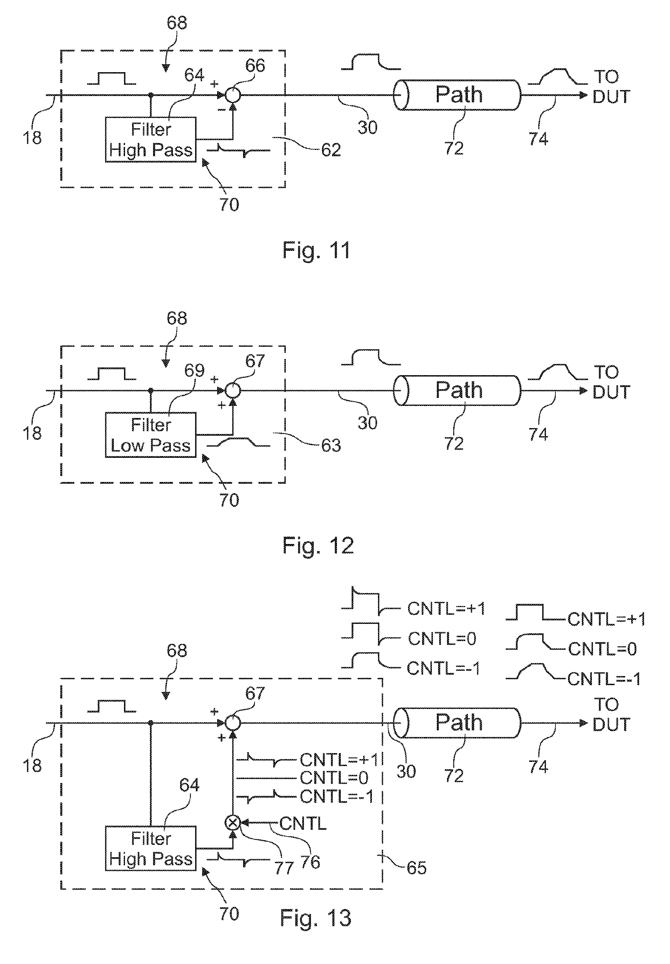

The signal shaping circuit according to the invention is well suited to be applied to ATE systems in order to simulate a transmission channel or transmission channel behavior and to generate a signal which approximates an output signal of a "real world" transmission channel. Fig. 11 shows an application of a first embodiment of a signal shaping circuit according to the invention adapted for application in an ATE system for generating an output signal of a typical transmission channel. The signal shaping circuit 62 may be integrated in the pin electronics of an ATE system or implemented as a separate module connected to the output side of the pin electronics. The circuit 62 receives a stimulus signal as input signal 18 for a DUT and shapes the received signal 18 in order to generate an output signal 30 having a shape similar to an output signal of a typical "real world" transmission channel. This output signal 30 is supplied to a signal path 72 of the ATE system, for example a wire line on a printed circuit board which connects the output of the circuit 62 with the input of the DUT. The signal path 72 further shapes the signal 30 received on its input. Thus, the signal 74 supplied to the DUT is similar to the output signal of a typical "real world" transmission channel and well suited to test the equalization functionality of the DUT in the GBit/s range. The shown signal shaping circuit 62 comprises two signal paths 68 and 70. The first signal path 68 comprises a first transmission behavior which corresponds to the transmission behavior of a short wire line and hardly influences the shape of the received input signal 18. The second signal path 70 comprises a high pass filter 64 and, therefore, has a second transmission behavior with a high pass filter characteristic. Thus, the second signal path 70 attenuates lower frequencies contained in the input signal 18. Therefore, the output signal of the second signal path 70 contains droop. A signal combiner 66 combines the output signals of the two signal paths 68 and 70 to the output signal 30, which is transmitted over the signal path 72, by subtracting the output signal of the second signal path 70 from the output signal of the first signal path 68.

Fig. 12 shows a second embodiment a signal shaping circuit 63 according to the invention which is adapted to be applied in an ATE system for generating an output signal of a typical "real world" transmission channel. This embodiment differs from the first embodiment of Fig. 11 in that the second signal path 70 comprises a low pass filter 69 and, therefore, has a low pass filter characteristic instead of a high pass filter characteristic. Thus, the output signal of the second signal path 70 is similar to a signal shaped by a transmission channel with a low pass filter characteristic. In order to achieve an output signal 30 similar to the output signal of a typical transmission channel, the signal combiner 67 applied in this signal shaping circuit 63 sums the output signals of the two signal paths 68 and 70.

Finally, Fig. 13 shows a third embodiment of a signal shaping circuit 65 according to the invention adapted for application in an ATE system. This signal shaping circuit 65 is programmable in order to achieve a highly flexible signal shaping for application in an ATE system. The signal shaping circuit 65 comprises a first and second signal path 68 and 70. The transmission behavior of the second signal path 70 is programmable by an control signal CNTL 76 which may be supplied from a controller of the ATE system. The control signal 76 is supplied to a multiplier 77 which receives as further input signal the output signal of a high pass filter 64 provided in the second signal path 70 for filtering and shaping the input signal 18 received from the pin electronic of the ATE system. The control signal 76 might be a digital signal with the values -1 and +1 as states, or an analog signal, preferably derived from an analog to digital converter and spanning a range between the values -1 and +1. It should be noted that the control signal 76 allows to adjust the transmission behavior of the second signal path 70, particularly the amplitude and/or the frequency of the output signal of the second signal path. By multiplying the output signal of the high pass filter 64 with the control signal 76, the output signal of the multiplier may be modified in a wide range in its amplitude, frequency, and phase.

In the following, the influence of a simple digital control signal 76 with three different states it is briefly explained, as an exemplary embodiment. However, it should be noted that the following description merely relates to an exemplary control signal 76 and the transmission behavior of the second signal path 70 by the control signal 76 may be adjusted in a much wider range depending on the selection of the control signal 76 and its range of adjustment. If the control signal has a value of +1, the transmission behavior of the second signal path corresponds to the transmission behavior of the second signal path of the signal shaping circuit as shown in Fig. 11, or in other words, the multiplication does not significantly influence the transmission behavior of the second signal path 70. If the control signal has a value of -1, the transmission behavior of the second signal path 70 is inverted. And if the control signal has a value of 0, the output signal of the second signal path is 0. It is clear from this description for a skilled person that other transmission behaviors of the second signal path may be achieved by applying another control signal and another filter in the signal path. with this circuit 65, a signal for stimulating a DUT may be varied in a wide range. Particularly, it allows to shape the stimulation signal in order to approximate an output signal of a "real world" transmission channel. This offers the possibility to test high speed serial data receivers in the GBit/s range under "real world" conditions.

## Claims

1. A signal shaping circuit (10) for shaping an input signal (18) comprising:
a first signal path (SP1) with a first transmission behavior and adapted to receive the input signal (18),
at least one second signal path (SP2-SPn) with a second transmission behavior and adapted to receive the input signal (18), and
a signal combiner (23) adapted to combine the output signals of the signal paths (SP1-SPn) to an output signal (30).

2. The signal shaping circuit of claim 1, wherein the transmission behavior of at least one signal path (70) is adjustable.

3. The signal shaping circuit of claim 2, wherein
the first signal path (SP1) comprises a first amplifier (12), and
the at least one second signal path (SP2-SPn) comprises a second amplifier (14, 16) with a low pass filter (20, 22) having an adjustable time constant for adjusting the transmission behavior of the at least one second signal path (SP2-SPn).

4. The signal shaping circuit of claim 3, wherein further the amplification of at least one amplifier (38, 40) is adjustable for adjusting the transmission behavior of a signal path (SP1, SP2).

5. The signal shaping circuit of claim 4, wherein the at least one amplifier (40) is a differential amplifier.

6. The signal shaping circuit of claim 5, wherein the differential amplifier (40) comprises an adjustable current source (I) for adjusting the amplification of the amplifier.

7. The signal shaping circuit of claim 3 or any one of the above claims, wherein the low pass filter (42) comprises a variable capacitor (C3) for adjusting the time constant, wherein the variable capacitor is connected between the output lines of the differential amplifier (40).

8. The signal shaping circuit of claim 3, or any of the above claims, wherein a decoupling stage (46) is connected between the low pass filter (42) and the signal combiner (23).

9. The signal shaping circuit of claim 1, wherein the at least one second signal path comprises an input amplifier (41) connected on its input to an input of the signal shaping circuit (10) and on its output to a low pass filter (42) with adjustable time constant, wherein the output of the low pass filter (42) is connected to the input of a differential amplifier (40) with adjustable amplification.

10. The signal shaping circuit of claim 1, or any of the above claims, wherein the signal combiner (23) comprise two resistors (R3, R4) both connected with one end to a variable voltage source (V1) and with the other end to the output lines of the signal paths (SP1-SPn).

11. The signal shaping circuit of claim 1, or any of the above claims, wherein at least one of the signal paths comprises an attenuation circuit (32, 34, 36).

12. The signal shaping circuit of claim 1, or any of the above claims, comprising two second signal paths with an adjustable transmission behavior.

13. The signal shaping circuit of claim 7, wherein the variable capacitor (CV1) is implemented by a circuit comprising two capacitance diodes (CD1, CD2), a resistor (R7), and a variable voltage source (V2), wherein the cathodes of the two capacitance diodes (CD1, CD2) are connected to the variable voltage source (V2) over the resistor (R7).

14. The signal shaping circuit of claim 7, wherein the variable capacitor (CV2) is implemented by a circuit comprising several series connections of a switch (S1-S3) and a capacitor (C4-C6), wherein the series connections are connected in parallel.

15. The signal shaping circuit of claim 1, or any of the above claims, adapted to receive adjusting signals (25, 27, 33, 35, 37) generated by a computer program for automatically adjusting the transmission behavior in accordance with predefined parameters.

16. The signal shaping circuit of claim 1, wherein one second signal path (70) comprises a filter (64) and the signal combiner (23) is adapted to combine the inverted output signal of the one second signal path (70) with the filter (64) with the output signals of the other signal paths (68).

17. The signal shaping circuit of claim 16, wherein at least one signal path (70) comprises a series connection of a filter (64) and a multiplier (77), wherein the multiplier (77) is provided for multiplying an output signal of the filter (64) with a control signal (76) in order to adjust the transmission behavior of the signal path (70).

18. The signal shaping circuit of claim 17, wherein the control signal (76) is a digital signal with several predefined states.

19. The signal shaping circuit of claim 17, wherein the control signal (76) is an analog signal adjustable within a predefined amplitude and frequency range.

20. The signal shaping circuit of claim 17, wherein the control signal is provided by a programmable controller.

21. A test instrument (50), comprising at least one signal shaping circuit (10) of any of the claims 1 to 20.

22. The test instrument of claim 21, wherein the test instrument is an automatic test equipment-ATE-system adapted for testing high speed serial data receivers.

23. The test instrument of claim 21, wherein the test instrument is pulse data generator adapted for generating a high speed serial data test signal.

24. The test instrument of claim 21, wherein the test instrument is bit error ratio - BERT - tester comprising a pulse data generation module which is adapted for generating a high speed serial data signal.

25. A signal shaping method for shaping an input signal (18) comprising:
providing the input signal (18) to a first signal path (SP1) with a first transmission behavior, and to at least one second signal path (SP2-SPn) with a second transmission behavior, and
combining output signals provided by the signal paths (SP1-SPn) to an output signal (30) of the signal shaping circuit (10).

26. A software program or product, preferably stored on a data carrier, for executing the method of claim 25, when run on a data processing system such as a computer.
